# EUROPÄISCHE PATENTSCHRIFT

(11) **EP 0 955 711 B1**
(45) Veröffentlichungstag und Bekanntmachung des Hinweises auf die Patenterteilung: **28.03.2001**
(21) Anmeldenummer: 99810374.1
(22) Anmeldetag: 03.05.1999
(51) Int. Cl.: H02B 1/40, H05K 7/00

(54) **Variabler Schrank**
Cabinet with adjustable size
Armoire à dimensions ajustables

(30) Priorität: 05.05.1998 CH 101198
(43) Veröffentlichungstag der Anmeldung: 10.11.1999
(73) Patentinhaber: Schlosser, Urs, 6340 Baar (CH)
(72) Erfinder: Wild, Rene, 6038 Honau (CH)
(74) Vertreter: Rutz, Peter

(56) Entgegenhaltungen:
- DE-A- 3 204 767
- DE-U- 1 955 004

## Beschreibung

Die vorliegende Erfindung betrifft einen insbesondere für die Montage von elektrischen oder elektronischen Elementen oder Baugruppen vorgesehenen Schrank nach dem Oberbegriff des Patentanspruchs 1.

Aus der Dokumentation 0395/5000 der Firma HWS Datanet AG, CH-8832 Wollerau ist ein Rack bzw. ein Schrank bekannt, der zum Einbau von elektrischen oder elektronischen Komponenten und Geräten vorgesehen ist, die mittels Tablaren, Einbaurahmen, Befestigungsprofilen oder Stellflächen in den Schrank eingebaut werden können.

Die einzubauenden Geräte und Baugruppen weisen je nach Anwendung und Hersteller unterschiedliche Abmessungen auf Normalerweise sind sie bezüglich der Breite normiert; weisen aber voneinander stark abweichende Tiefen auf. Die Tiefe des für die Aufnahme dieser Geräte und Baugruppen vorgesehenen Schrankes ist daher entsprechend zu bemessen.

Der Hersteller der Schränke muss daher Schränke mit verschiedenen Einbautiefen in seinem Sortiment führen. Die für den Einbau der Komponenten und Geräte zuständigen Spezialisten müssen vor der Bestellung der Schränke die benötigte Einbautiefe genau feststellen. Da mögliche Änderungen oder spätere Ausbaustufen meist nicht genau voraussehbar sind, müssen Schränke oft mit erheblichen Kostenfolgen vor, während oder nach der Installation wieder ausgetauscht werden.

Aus der Offenlegungsschrift DE 19 55 004 U ist eine Unterputz-Kleinverteilung aus Kunststoff bekannt, die einen Mauerkasten aufweist, in den hinein ein mit einer Tür verbindbarer Blendrahmen schiebbar und in einer geeigneten Position mittels elastisch federnden Befestigungslappen, die in sägezahnartig ausgebldete Flächen an der Innenseite des Mauerkastens einrasten, fixierbar ist. Bei dieser Lösung sollen alle Teile der Unterputz-Kleinverteilung ohne Verwendung von Verbindungslementen zeit- und kostensparend miteinander verbunden werden können. Der Blendrahmen, der nicht Teil der tragenden Struktur der Unterputz-Kleinverteilung bildet, kann daher soweit in den unter Putz befestigten Mauerkasten hineinverschoben werden, bis er am Putz anliegt. Die Grösse der in die Unterputz-Kleinverteilung aufnehmbaren Vorrichtungen richtet sich daher im wesentlichen nach den konstanten Abmessungen des Mauerkastens.

Aus der Offenlegungsschrift DE 32 04 767 A1 ist ein in modularer Bauweise hergestellter Verteilerkasten bekannt, der aus zwei spiegelbildlichen Seitenbauteilen und mindestens einem Zwischenbauteil besteht. Durch Einfugen mehrerer Zwischenbauteile kann die Breite des Kastens schrittweise vergrößert werden. Nachteilig bei dieser Lösung ist, dass Zwichenbauteile benötigt werden, die eine Änderung der Kastengrösse nur in entsprechend grossen Schritten erlauben.

Der Erfindung liegt daher die Aufgabe zugrunde, einen Schrank zu schaffen, der sich den Bedürfnissen des Anwenders variabel anpassen lässt

Diese Aufgabe wird durch die im Patentanspruch 1 angegebenen Massnahmen gelöst Vorteilhafte Ausgestaltungen der Erfindung sind in weiteren Ansprüchen angegeben.

Erfindungsgemäss sind zwei ineinander verschiebbare und fixierbare Schrankschalen vorgesehen, die die tragende Struktur und gegebenenfalls die Seitenwände und die Rückwand des Schrankes bilden. Die beiden Schrankschalen sind durch eine Tür oder durch eine mit einer Tür versehene Frontschale abschliessbar, in die hinein die beiden Schrankschalen verschiebbar sind. Sofern aufgrund ästhetischer oder technischer Anforderungen notwendig können die Schrankschalen durch Seiten- oder Deckplatten abgeschlossen werden.

Der erfindungsgemässe Schrank kann kostengünstig hergestellt und mit einfachen Massnahmen installiert werden. Die Tiefe des Schrankes lässt sich vorzugsweise in kleinen Schritten oder auch stufenlos einstellen.

Die Erfindung wird nachfolgend anhand einer Zeichnung beispielsweise näher erläutert. Dabei zeigt:
- Fig. 1: eine erste Schrankschale 1,
- Fig. 2: die erste und eine zweite Schrankschale 1 bzw. 2,
- Fig. 3: die beiden ineinander verschobenen Schrankschalen 1 und 2 sowie eine mit einer Tür 36 versehene Frontschale 3,
- Fig. 4: die Schrankelemente 1, 2 und 3 nach der Montage mit Abdeckplatten 41 und 42,
- Fig. 5: die beiden Schrankschalen 1 und 2a vor der Montage von der Seite gezeigt und
- Fig. 6: die beiden Schrankschalen 1 und 2a ineinander verschoben und fixiert.

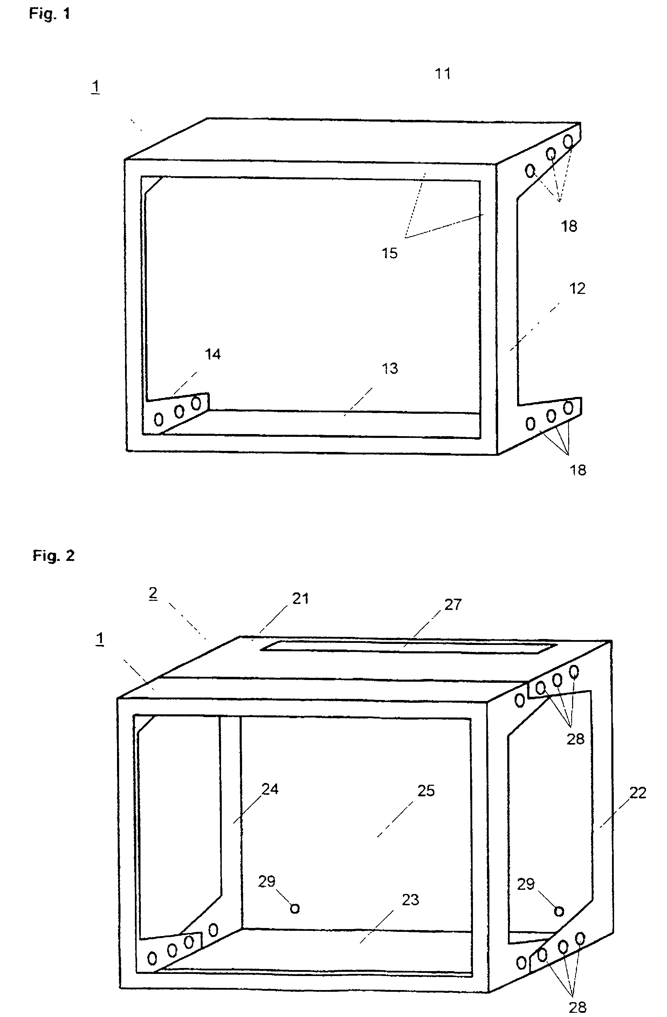

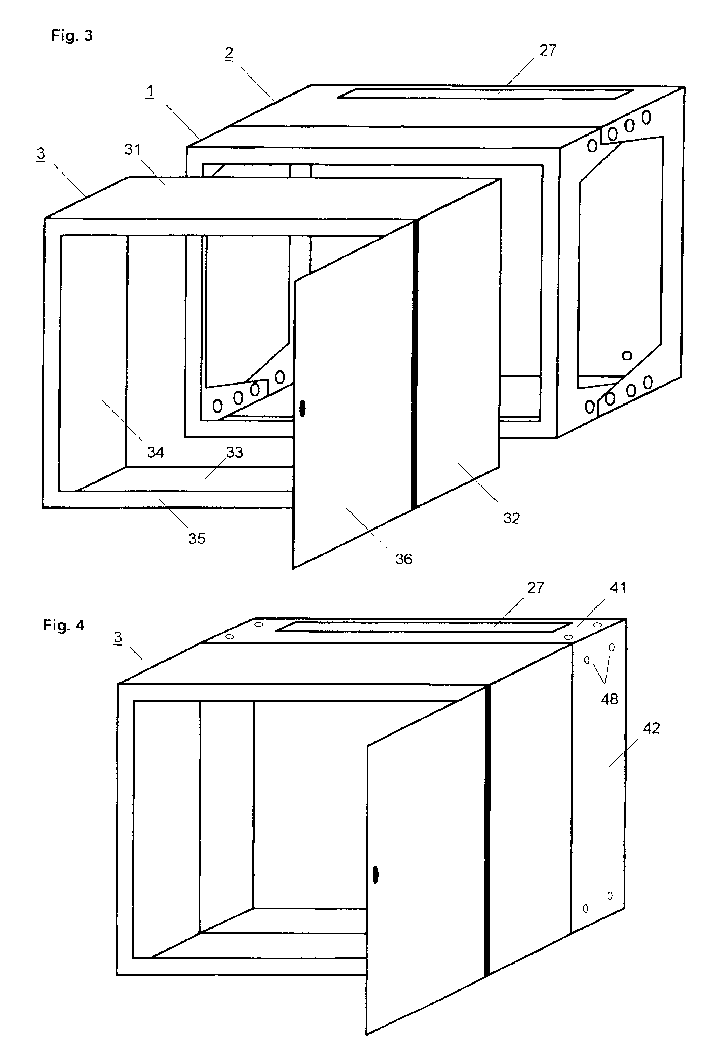

Fig. 1 zeigt eine erste Schrankschale 1, die durch eine Deck- und eine Grundplatte 11 bzw. 13 miteinander verbundene Seitenplatten 12 bzw. 14 aufweist. Die dadurch gebildete rechteckige Öffnung ist vorzugsweise durch einen Rahmen 15 begrenzt, der z.B. zur Montage der in Fig. 3 gezeigten Frontschale 3 und/oder zur Montage von Befestigungselementen dient, mit denen die einzubauenden Geräte verbunden werden. Die beiden Seitenplatten 12 und 14, die grössere Ausnehmungen aufweisen, sind mit mehreren Gewindebohrungen 18 versehen, die zur Befestigung einer zweiten Schrankschale 2 dienen.

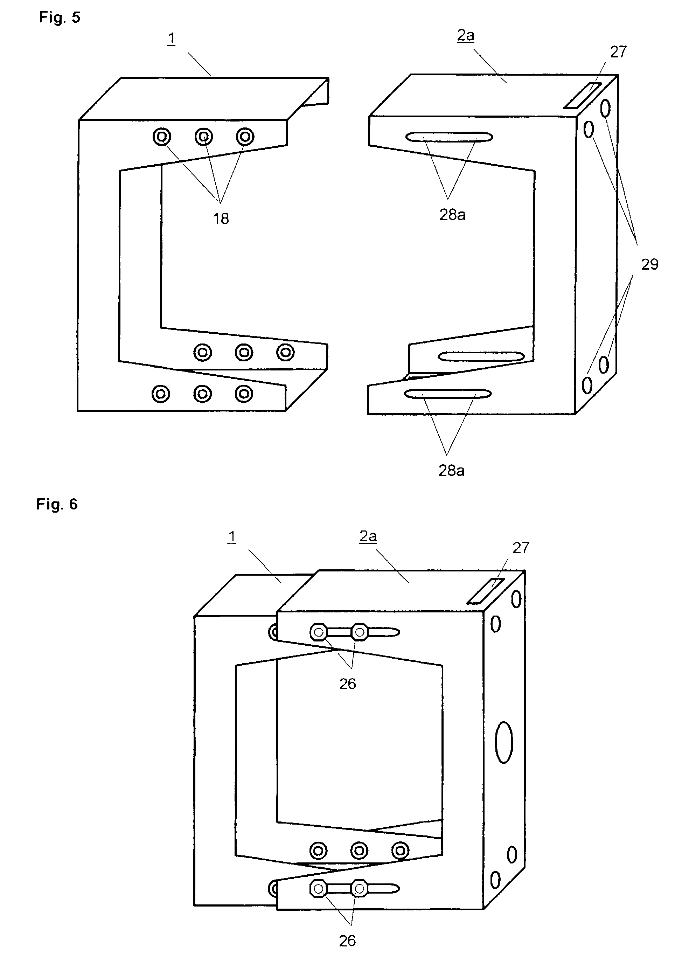

In Fig. 2 ist die erste Schrankschale 1 in eine zweite Schrankschale 2 hinein verschoben, die ebenfalls zwei mit Ausnehmungen versehene Seitenplatten 22 bzw. 24 aufweist, die durch eine Deck- und eine Grundplatte 21 bzw. 23 miteinander verbunden sind. Die Seitenplatten 22 bzw. 24 weisen mehrere Bohrungen 28 auf, die auf derselben Höhe vorgesehen sind wie die Gewindebohrungen 18 der Seitenplatten 12 und 14 der ersten Schrankschale 1. Durch Ineinanderschieben der beiden Schrankschalen 1 und 2 überlagem sich in kurzen Abständen jeweils wieder wenigstens eine Gewindebohrung 18 und eine Bohrungen 28, so dass die beiden Schrankschalen 1 und 2 durch Schrauben 26 (siehe Fig. 5 und Fig. 6) in verschiedenen gegeneinander verschobenen Positionen fixiert werden können. Aus Fig. 2 und Fig. 5 ist ersichtlich, dass die zweite Schrankschale 2 eine Rückwand 25 aufweist, die mit Bohrungen 29 versehen ist, die zur Befestigung des Schrankes dienen. Zur Zuführung von Anschlusskabeln für die montierten Geräte ist vorzugsweise die Deckplatte 21 der zweiten Schrankschale 2 mit einer Öffnung 27 versehen.

Die beiden Schrankschalen 1 und 2 sind in einer ersten Ausgestaltung mit einer Tür abschliessbar, die vorzugsweise mit dem Rahmen 15 der ersten Schrankschale 1 verbunden ist. Zum Abschliessen der Tür weisen dieselbe und der Rahmen 15 eine Abschliessvorrichtung auf.

U.a. zur Reduktion des Gewichts sind die Seitenplatten 12, 14, 22 und 24 der beiden Schrankschalen 1 und 2 (gegebenenfalls auch die Deck- und Bodenplatten 11, 13, 21 und 23) vorzugsweise mit grösseren Ausnehmungen versehen. Zum Abdecken der beiden mit Ausnehmungen versehenen Schrankschalen 1 und 2 ist in Fig. 3 eine Frontschale 3 vorgesehen, die vorzugsweise eine Grund- und eine Deckplatte 31 bzw. 33, zwei Seitenplatten 32, 34 und einen damit verbundenen Frontrahmen 35 aufweist, an dem eine Tür 36 angeschlagen ist.

Fig. 4 zeigt den erfindungsgemässen Schrank nach der Montage. Die vorzugsweise mit der ersten Schrankschale 1 verschraubte Frontschale 3 umfasst die erste Schrankschale 1 vollständig und die zweite Schrankschale 2 teilweise. Die offenen Ausnehmungen der zweiten Schrankschale 1 bzw. 2 sind mit Abdeckplatten 41 und 42 abgeschlossen, die mittels Schrauben 48 befestigt sind. Sofern die Deckplatte 21 der zweiten Schrankschale 2 mit einer der Zuführung von Anschlusskabeln dienenden Öffnung 27 versehen ist, so ist auch eine entsprechende Öffnung in der Abdeckplatte 41 vorzusehen.

Fig. 5 und Fig. 6 zeigen eine vorzugsweise Ausgestaltung der zweiten Schrankschale 2, die, anstelle von Bohrungen 28, Schlitze 28a aufweist, die zur Aufnahme von Schrauben 26 vorgesehen sind, die durch die Schlitze 28a hindurch geführt und in die Gewindebohrungen 18 gedreht sind. In Fig. 6 ist leicht ersichtlich, dass die beiden Schrankschalen 1 und 2 dadurch stufenlos ineinander verschiebbar und in beliebigen Positionen fixierbar sind. Die Bereiche der beiden Schrankschalen 1 und 2, die beim Befestigen der Schrauben 26 aufeinander gepresst werden, werden vorzugsweise mit Rillen versehen, die nach der Montage formschlüssig ineinander greifen und ein weiteres gegenseitiges Verschieben der Schrankschalen 1 und 2 verhindern.

Selbstverständlich sind nebst den beispielsweise angegebenen Ausgestaltungen der Erfindung verschiedenste weitere fachmännische Ausgestaltungen denkbar. Z.B. könnte die zweite Schrankschale in die erste hinein verschoben werden. Femer können Befestigungsmittel ausgetauscht oder anders positioniert werden.

Weiterhin können Schrankschalen verwendet werden, die keine Ausnehmungen aufweisen. Der erfindungsgemässe Schrank kann daher z.B. auch in Wohnungen oder Büros u.a. auch als Einbauschrank vorteilhaft verwendet werden, der sich einer vorhandenen Einbautiefe präzise anpassen lässt.

## Patentansprüche

1. Variabler, insbesondere für die Montage von elektrischen oder elektronischen Elementen oder Baugruppen dienender Schrank, **dadurch gekennzeichnet**, dass zwei ineinander verschiebbare und in verschiedenen, gegeneinander verschobenen Positionen gegenseitig fixierbare Schrankschalen (1, 2) vorgesehen sind, welche die tragende Struktur des Schrankes bilden.

2. Variabler Schrank nach Anspruch 1, **dadurch gekennzeichnet**, dass die Schrankschalen (1, 2) durch eine Deck- und eine Grundplatte (11, 13 bzw. 21, 23) miteinander verbundene Seitenplatten (12, 14 bzw. 22, 24) aufweisen.

3. Variabler Schrank nach Anspruch 1 oder 2, **dadurch gekennzeichnet**, dass die erste und/oder die zweite Schrankschale (2) mit wenigstens einer der Durchführung von Anschlusskabeln dienenden Öffnung (27) versehen ist

4. Variabler Schrank nach Anspruch 1, 2 oder 3, **dadurch gekennzeichnet**, dass die erste und/oder die zweite Schrankschale (1; 2) mit Ausnehmungen versehen sind oder durchgehende Flächen aufweisen.

5. Variabler Schrank nach einem der Ansprüche 1 bis 4, **dadurch gekennzeichnet**, dass eine der beiden Schrankschalen (1; 2) Gewindebohrungen(18) und die andere entsprechend angeordnete Öffnungen (28, 28a) aufweist, durch die hindurch Schrauben (26) führbar sind, mittels denen die beiden Schrankschalen (1,2) fest verbindbar sind.

6. Variabler Schrank nach Anspruch 5, **dadurch gekennzeichnet**, dass die Öffnungen (28a) schlitzförmig ausgestaltet sind, so dass die beiden Schrankschalen (1, 2) stufenlos gegeneinander verschiebbar und fixierbar sind.

7. Variabler Schrank nach einem der Ansprüche 1 bis 6, **dadurch gekennzeichnet**, dass die erste Schrankschale (1) einen Rahmen (15) aufweist, der zur Befestigung von Elementen, Geräten und/oder Baugruppen dient.

8. Variabler Schrank nach einem der Ansprüche 1 bis 7, **dadurch gekennzeichnet**, dass die erste Schrankschale (1) mit einer Tür versehen ist.

9. Variabler Schrank nach einem der Ansprüche 1 bis 7, **dadurch gekennzeichnet**, dass eine Frontschale (3) vorgesehen ist, die zumindest über die erste Schrankschale (1) schiebbar ist.

10. Variabler Schrank nach Anspruch 9, **dadurch gekennzeichnet**, dass die Frontschale (3) eine Grund- und eine Deckplatte (31 bzw. 33), zwei Seitenplatten (32, 34) und einen damit verbundenen Frontrahmen (35) aufweist, an dem eine Tür (36) angeschlagen ist und/oder dass Platten (41, 42) vorgesehen sind, die insbesondere zum Abdecken der Ausnehmungen der beiden Schrankschalen (1, 2) dienen.

## Claims

1. Variable cabinet serving, in particular, for the installation of electrical or electronic elements or subassemblies, characterized in that there are provided two cabinet shells (1, 2) which can be displaced one inside the other, can be fixed in relation to one another in different, mutually displaced positions, and which form the load-bearing structure of the cabinet.

2. Variable cabinet according to Claim 1, characterized in that the cabinet shells (1, 2) have side panels (12, 14 and 22, 24, respectively) which are connected to one another by a cover panel and a base panel (11, 13 and 21, 23, respectively).

3. Variable cabinet according to Claim 1 or 2, characterized in that the first cabinet shell and/or the second cabinet shell (2) are/is provided with at least one opening (27) serving for the through-passage of connection cables.

4. Variable cabinet according to Claim 1, 2 or 3, characterized in that the first cabinet shell and/or the second cabinet shell (1; 2) are/is provided with cutouts or have/has continuous surfaces.

5. Variable cabinet according to one of Claims 1 to 4, characterized in that one of the two cabinet shells (1; 2) has threaded bores (18) and the other has correspondingly arranged openings (28, 28a), through which it is possible to guide screws (26) by means of which the two cabinet shells (1, 2) can be connected firmly.

6. Variable cabinet according to Claim 5, characterized in that the openings (28a) are of slot-like configuration, with the result that the two cabinet shells (1, 2) can be displaced in a stepless manner in relation to one another and fixed.

7. Variable cabinet according to one of Claims 1 to 6, characterized in that the first cabinet shell (1) has a frame (15) which serves for fastening elements, units and/or subassemblies.

8. Variable cabinet according to one of Claims 1 to 7, characterized in that the first cabinet shell (1) is provided with a door.

9. Variable cabinet according to one of Claims 1 to 7, characterized in that there is provided a front shell (3) which can be pushed at least over the first cabinet shell (1).

10. Variable cabinet according to Claim 9, characterized in that the front shell (3) has a base panel and a cover panel (31 and 33), two side panels (32, 34) and a front frame (35) which is connected thereto and on which a door (36) is fastened, and/or in that there are panels (41, 42) which serve, in particular, for covering the cutouts of the two cabinet shells (1, 2).

## Revendications

1. Armoire à dimensions ajustables, servant en particulier au montage d'éléments ou de modules électriques ou électroniques, **caractérisée en ce qu**'il est prévu deux coques d'armoire (1, 2) pouvant être poussées l'une dans l'autre et fixées dans des positions différentes, déplacées l'une contre l'autre, et qui forment la structure portante de l'armoire.

2. Armoire à dimensions ajustables selon la revendication 1, caractérisée en ce que les coques d'armoire (1, 2) présentent des plaques latérales (12, 14, respectivement 22, 24) connectées l'une à l'autre par une plaque de recouvrement et une plaque de base (11, 13, respectivement 21, 23).

3. Armoire à dimensions ajustables selon la revendication 1 ou 2, **caractérisée en ce que** la première et/ou la deuxième coque d'armoire (2) est pourvue d'au moins une ouverture (27) servant au passage de câbles de connexion.

4. Armoire à dimensions ajustables selon la revendication 1, 2 ou 3, **caractérisée en ce que** la première et/ou la deuxième coque d'armoire (1; 2) sont pourvues d'évidements ou présentent des faces continues.

5. Armoire à dimensions ajustables selon l'une quelconque des revendications 1 à 4, **caractérisée en ce que** l'une des deux coques d'armoires (1; 2) présente des alésages filetés (18) et l'autre des ouvertures (28, 28a) disposées de manière correspondante, à travers lesquelles peuvent être guidées des vis (26) au moyen desquelles les deux coques d'armoire (1, 2) peuvent être connectées fixement.

6. Armoire à dimensions ajustables selon la revendication 5, **caractérisée en ce que** les ouvertures (28a) sont configurées en forme de fente, de sorte que les deux coques d'armoire (1, 2) puissent être déplacées progressivement l'une contre l'autre et fixées.

7. Armoire à dimensions ajustables selon l'une quelconque des revendications 1 à 6, **caractérisée en ce que** la première coque d'armoire (1) présente un cadre (15), qui sert à la fixation d'éléments, appareils et/ou modules.

8. Armoire à dimensions ajustables selon l'une quelconque des revendications 1 à 7, **caractérisée en ce que** la première coque d'armoire (1) est pourvue d'une porte.

9. Armoire à dimensions ajustables selon l'une quelconque des revendications 1 à 7, **caractérisée en ce qu**'il est prévu une coque avant (3) qui peut être poussée au moins par-dessus la première coque d'armoire (1).

10. Armoire à dimensions ajustables selon la revendication 9, **caractérisée en ce que** la coque avant (3) présente une plaque de base et une plaque de recouvrement (31, respectivement 33), deux plaques latérales (32, 34) et un cadre avant (35) connecté à celles-ci, auquel est accrochée une porte (36) et/ou en ce qu'il est prévu des plaques (41, 42) qui servent en particulier à recouvrir les évidements des deux coques d'armoire (1, 2).
